# EUROPÄISCHE PATENTSCHRIFT

(11) **EP 4 383 975 B1**
(45) Veröffentlichungstag und Bekanntmachung des Hinweises auf die Patenterteilung: **12.02.2025**
(21) Anmeldenummer: 22020604.9
(22) Anmeldetag: 08.12.2022
(51) Int. Cl.: H05K 13/00

(54) **BAUTEILMAGAZIN UND ANLAGE ZUR MONTAGE VON BAUTEILEN AUF EINER TRAGSCHIENE**
COMPONENT MAGAZINE AND INSTALLATION FOR MOUNTING COMPONENTS ON A SUPPORT RAIL
MAGASIN DE COMPOSANTS ET INSTALLATION DE MONTAGE DE COMPOSANTS SUR UN RAIL DE SUPPORT

(43) Veröffentlichungstag der Anmeldung: 12.06.2024
(73) Patentinhaber: Phoenix Mecano Solutions AG, 8260 Stein am Rhein (CH)
(72) Erfinder: JAHN, Michael, 8200 Schaffhausen (CH)
(74) Vertreter: Jendricke, Susann

(56) Entgegenhaltungen:
- DE-A1- 2 751 856

## Beschreibung

Die vorliegende Erfindung betrifft ein Bauteilmagazin zur Bereitstellung von Bauteilen mit einer Aufnahme, wobei die Aufnahme ein Beschickungsende und ein Entnahmeende aufweist, an dem das zu entnehmende Bauteil entnehmbar ist, wobei die Aufnahme um eine Drehachse rotierbar ist und von einer Horizontalstellung in eine Kippstellung verbringbar ist, wobei in der Kippstellung das Entnahmeende in eine nach unten, zum Boden orientierte Richtung weist und wobei die Aufnahme wieder in die Horizontalstellung rotierbar ist. Die Erfindung betrifft weiter eine Anlage zur Montage von Bauteilen auf einer Tragschiene, die ein Bauteilmagazin, ein Werkzeug zur Entnahme des Bauteils aus dem Bauteilmagazin und zur Montage des Bauteils auf der Tragschiene umfasst.

Bauteilmagazine sind beispielsweise im Bereich der Elektrotechnik bekannt. Elektrotechnische Bauteile, wie Klemmen, Schütze, Stromversorgungen, Steuereinheiten werden über Werkzeuge, wie Roboter-Greifarme, dem Magazin entnommen und schließlich auf Tragschienen, wie Hutschienen, C-Schienen, G-Schienen verschiedener Breiten verbunden. Die Tragschienen, die auch als Elektroschienen bezeichnet werden, werden beispielsweise in Schaltschränken verbaut, wo in den elektrotechnischen Bauteilen dann entsprechende elektrische Leitungen befestigt werden. Hutförmige Tragschienen sind bei elektrotechnischen Bauteilen mit Schnappfuß unumgänglich. Die Tragschienen könnten auch auf Montageplatten aufgebracht sein, was bspw. im Hinblick auf eine Gesamtanlage häufig der Fall ist. Alternative Bauteile, die von den zuvor geschilderten elektrotechnischen Bauteilen verschieden sind, könnten direkt auf einer Montageplatte montiert werden oder in eine Verpackung einsortiert werden oder dergleichen. Über die Anwendung im Bereich der Elektrotechnik hinaus, können Bauteilmagazine auch in der Spielzeug-, Verpackungs-, Medikamenten- oder Lebensmittelindustrie Anwendung finden.

Aus der Praxis sind im Bereich der elektrotechnischen Bauteile Bauteilmagazine bekannt, in denen die Bauteile vertikal gestapelt sind. Das Beschickungsende befindet sich oben, das Entnahmeende befindet sich unten und ist so gestaltet, dass ein Werkzeug, insbesondere ein Roboter-Greifarm, bequem Zugriff hat. Einerseits ist es zwar vorteilhaft, dass weitere Bauteile, die auf dem zu entnehmenden Bauteil aufgestapelt sind, durch die Schwerkraft selbsttätig aufliegen. Nachteilig ist aber, dass bei vielen Bauteilen der Druck, der gerade auf das zu entnehmende und zuunterst liegende Bauteil ausgeübt wird, enorm ist. Bei einer solchen Sachlage muss ein Roboter beim Greifen und Herausziehen des zu entnehmenden Bauteils diesen enormen Druck überwinden, was zum Verrutschen der Bauteile führen kann. Dies wiederum führt dazu, dass entnommene Bauteile vom Greifer des Roboters herunterfallen können oder dass durch die Verschiebung das Bauteil nicht ordnungsgemäß auf die Tragschiene aufgesetzt werden kann. Der in der Praxis mit Mängeln behaftete Übergang des Bauteils vom Magazin zur Entnahmevorrichtung hat nachteilige Auswirkungen auf die Qualität des weiteren Handlings des Bauteils im Hinblick auf die Bestückung von bereitstehenden Montage-Tragschienen oder Ablagen, die in der Regel die Einhaltung bestimmter vorgegebener Koordinaten erfordern. Die mit den Nachteilen verbundenen Produktionsausfälle kosten Zeit und Geld.

Die Druckschrift DE 27 51 856 A1 zeigt eine Aufnahme, die zur Entleerung in eine Kippstellung verbringbar ist.

Der Erfindung liegt die Aufgabe zugrunde, ein Bauteilmagazin der in Rede stehenden Art und eine das Bauteilmagazin umfassende Anlage anzugeben, wobei eine verbesserte, präzise Entnahme eines Bauteils aus dem Magazin ermöglicht wird. Darüber hinaus soll bezüglich der das Bauteilmagazin umfassenden Anlage eine sichere und positionsgenaue Befestigung der aus dem Bauteilmagazin entnommenen Bauteile auf einer Tragschiene ermöglicht werden.

Die voranstehende Aufgabe wird durch die Merkmale des Patentanspruches 1 gelöst. Danach ist ein Bauteilmagazin der in Rede stehenden Art derart ausgestaltet und weitergebildet, dass sich die Bauteile zur Vorbereitung der Bauteilentnahme in der Kippstellung bis zu einem Anschlag am Entnahmeende der Aufnahme bewegen und dass zur Entnahme des Bauteils die Aufnahme in die Horizontalstellung rotierbar ist.

Die voranstehende weiterführende Aufgabe wird in Bezug auf eine Anlage, welche das erfindungsgemäße Bauteilmagazin umfasst, durch die Merkmale des Patentanspruches 8 gelöst. Danach ist eine Anlage der in Rede stehenden Art derart ausgestaltet und weitergebildet, dass eine Spanneinrichtung mit mindestens einem Spannelement vorgesehen ist, die im Betriebszustand eine Spannkraft auf die Tragschiene ausübt.

Zunächst ist erkannt worden, dass bei dem aus der Praxis bekannten Bauteilmagazin mit vertikal übereinander geordneten Bauteilen der auf das zuunterst liegende und zu entnehmende Bauteil ausgeübte Druck die Entnahme und eine präzise Bestückung erschwert. Durch den Druck wird beim zu entnehmenden Bauteil ein Widerstand erzeugt, der dazu führt, dass ein Werkzeug dieses nicht präzise entnehmen kann und in der Folge auch nicht präzise auf einer Tragschiene positionieren und montieren kann. Eine Änderung der Drucksituation ist eine erste erfinderische Idee. Durch die Druckschrift DE 2751856 wurde zwar eine Entleerung in Kippstellung der Aufnahme angeboten, aber die gewünschte Präzision bei der Entnahme lässt sich damit nicht relisieren. Erfindungsgemäß erkannt worden, die Entnahmeposition des zu entnehmenden Bauteils zu ändern. Erfindungsgemäß ist weiter erkannt worden, dass das zu entnehmende Bauteil vorbereitend positioniert werden kann und insbesondere auch die Schwerkraft sowie die Druckbeaufschlagung durch nachfolgende Bauteile genutzt werden kann, wenn die Aufnahme von einer Horizontalstellung in eine Kippstellung rotierbar ist, so dass die nachgeordneten Bauteile in einer nach unten, zum Boden orientierten Kippstellung dank der Schwerkraft gegen einen Anschlag am Entnahmeende rutschen und so eine Positionierung des zu entnehmenden Bauteils am Anschlag stattfindet. In Abkehr von der Lehre gemäß DE 27 51 856 A1 ist es schließlich erfindungsgemäß erkannt worden, die Aufnahme nach Abschluss der vorbereitenden Positionierung in der Kippstellung wieder in die
Horizontalstellung zu rotieren, wo dann das zu entnehmende Bauteil präzise positioniert, aber erfindungsgemäß vom Druck nachfolgender Bauteile unbelastet, von einem Werkzeug ohne Probleme entnommen und später montiert werden kann.

Erfindungsgemäß ist weiterführend erkannt worden, dass die Sicherheit der auf der Tragschiene montierten Bauteile im Hinblick auf ihre genaue Position und ihren Verbleib dank der erfindungsgemäßen Spanneinrichtung gewährleistet werden kann. Die sichere Montage wird erfindungsgemäß dadurch erreicht, dass die Tragschiene so gespannt wird, dass einerseits die Montage der montierten Bauteile in der gewünschten Position realisiert werden kann und andererseits auch ein Verlust der darauf angeordneten Bauteile ausgeschlossen ist. Die Spannkraftbeaufschlagung wird vorrangig mit dem Ziel durchgeführt, die Position der Tragschiene zu determinieren. Weiterführend könnten die Tragschienenkanten gemäß einer bevorzugten, für die Erfindung sehr vorteilhaften Ausgestaltung für Bauteile mit Schnappfuß in einer für das Einschnappen des Schnappfußes optimalen Position gehalten werden.

Das Bauteilmagazin könnte einerseits durch Drehung um die Längsachse in die Kippstellung gebracht werden. Im Anwendungsbereich von elektrotechnischen Bauteilen könnte die Drehachse quer zur Längsachse der Aufnahme verlaufen, da hier quer zur Längsachse der Aufnahme eine Vielzahl von elektrotechnischen Bauteilen hintereinander geordnet sind.

Damit die Positionierung des zu entnehmenden Bauteils von Beginn an unterstützt wird, könnte die Aufnahme Führungsmittel aufweisen, die auf die Formgebung des Bauteils abgestimmt sind. Gemäß einer bevorzugten Ausgestaltung könnten entlang der Innenseiten der Aufnahme Führungsdrähte vorgesehen sein, die mit der Außenkontur des jeweiligen Bauteils korrespondieren. Darüber hinaus könnten Führungsdrähte auch am Boden der Aufnahme vorgesehen sein.

Im Hinblick auf eine ungehinderte Entnahme des zum Anschlag am Entnahmeende nächstliegenden Bauteils könnten die Führungsmittel einen Abstand zum Anschlag am Entnahmeende aufweisen, dessen Abmessung zumindest geringfügig größer ist als die Tiefenabmessung des zu entnehmenden Bauteils. Besonders gilt dies für die seitlichen Führungsdrähte. Die Entnahme durch das Werkzeug wird in vorteilhafter Weise erfindungsgemäß durch die Vermeidung eines Druckaufbaus durch nachfolgende Bauteile und besonders vorteilhaft ergänzend durch die positionstreue Zuführung und die Freigabemaßnahmen im Abstand zum Anschlag am Entnahmeende optimiert. Alternativ zur Entnahme des Bauteils mittels eines Werkezeuges könnte auch eine manuelle Entnahme durch eine Person realisiert werden.

Bei Bauteilen mit geringem Gewicht könnte zur Sicherstellung der vollständigen Bewegung der in der Aufnahme befindlichen Bauteile während der Kippstellung bis zum Anschlag am Entnahmeende ein Gewicht, insbesondere ein mit Blei gefüllter Wagen, innerhalb der Aufnahme vorgesehen sein. Dieses Gewicht könnte das Bauteil kontaktieren, welches dem Beschickungsende am nächsten ist, dieses durch das Gewicht mit Druckkraft beaufschlagen und damit alle Bauteile zum Anschlag schieben.

Das erfindungsgemäße Bauteilmagazin könnte zur Realisierung der Kippbewegung der Aufnahme an deren Unterseite mindestens ein Drehlager vorsehen, das auf einer Führungsstange aufsitzt. Die Führungsstange könnte vertikal beweglich in Führungen zweier beabstandeter Gestellbauteile eines Gestells gelagert sein. Hier könnte es sich bspw. um Vertikalstützen handeln. Das insbesondere über motorische Antriebe realisierbare Herauf- und Herunterfahren der Führungsstange führt zum Positionswechsel des Entnahmeendes der Aufnahme. Bei Aufnahmen, die eine größere Längenabmessung aufweisen, könnte ein zweites Drehlager mit einer zweiten Führungsstange vorgesehen sein, das benachbart zum Beschickungsende angeordnet ist, wobei die Enden der zweiten Führungsstange in beweglichen Führungen des Gestells in der Höhe nach oben und unten gefahren werden können. In der Kippstellung befindet sich die zum Entnahmeende benachbarte erste Führungsstange auf einem geringeren Höhenniveau bzw. in einem geringeren Abstand zum Boden oder Untergrund während die zum Beschickungsende benachbarte zweite Führungsstange nach oben verfahren ist und einen wesentlich größeren Abstand zum Untergrund aufweist. Alternativ könnte die erste Führungsstange auch fixiert sein und die Drehachse ausbilden, wenn das Höhenniveau der ersten Führungsstange dem gewünschten Entnahmeniveau entspricht.

Der Grad der Kippstellung bzw. der Winkel zwischen Horizontalstellung und Kippstellung richtet sich nach den konstruktiven Erfordernissen des zu entnehmenden Werkzeuges. Gemäß einer bevorzugten Ausführungsform hat sich zwischen der Horizontalstellung und der Kippstellung der Aufnahme ein Drehwinkel im Bereich von 10° bis 80° herausgestellt. Häufig, jedoch in Abhängigkeit von der Quantität und Qualität der Bauteile oder vom Vorhandensein eines Gewichts / Wagens, konnte der Drehwinkelbereich bei 30° bis 50 ° festgestellt werden.

Auf jeden Fall ist zu gewährleisten, dass es zur vollständigen Bewegung der in der Aufnahme befindlichen Bauteile bis zum Anschlag kommt, und beim erneuten Erreichen der Horizontalstellung das zu entnehmende Bauteil druckfrei am Anschlag verbleibt, damit die Entnahme fehlerfrei stattfinden kann.

Statt der bisher erläuterten Aufnahme, in der eine Vielzahl von Bauteilen hintereinander geordnet sind, könnten innerhalb eines großformatigen erfindungsgemäßen Bauteilmagazins mehrere Aufnahmen angeordnet seine. Diese könnten auf jeweils ein spezifisches Bauteil abgestimmt und sowohl nebeneinander als auch alternativ oder zusätzlich übereinander angeordnet sein.

Bei mehreren nebeneinander geordneten Aufnahmen könnten diese theoretisch einzeln gekippt werden. Gemäß einer bevorzugten Ausgestaltung sind allen nebeneinander geordneten Aufnahmen auf einer Ebene Drehlager in Nachbarschaft zum Beschickungsende und in Nachbarschaft zum Entnahmeende zugeordnet, so dass sie jeweils auf einer gemeinsame erste Führungsstange und auf einer gemeinsamen zweiten Führungsstange angeordnet werden können und gemeinsam eine Kippbewegung ausführen. Auf diese Wiese wird die Möglichkeit eröffnet, dass in einem einzigen Kippvorgang entsprechend der Anzahl der Aufnahmen auch entsprechende Werkzeuge Bauteile entnehmen könnten. Die Weiterführung dieses Gedankens zieht die Ausgestaltung des Werkzeuges, insbesondere eines Roboters nach sich, der eine entsprechende Anzahl an Greifarmen aufweist, die zur Entnahme des jeweiligen spezifischen Bauteils ausgestaltet sind. Der Charakter der gesamten Anlage könnte um eine Vielzahl von Montageplätzen mit Tragschienen, Montageplatten und dergleichen erweitert werden. Eine Steuerung würde Reihenfolge und Diversität der Montageschritte für mehrere Greifarme gleichzeitig koordinieren.

Das erfindungsgemäße Bauteilmagazin könnte Bestandteil einer erfindungsgemäßen Anlage zur Montage von Bauteilen auf der Tragschiene sein, die zudem noch das bereits erwähnte Werkzeug zur Entnahme des Bauteils aus dem Bauteilmagazin und einen Montageplatz zur Montage des Bauteils auf der Tragschiene umfasst. Die erfindungsgemäße Anlage zeichnet sich dadurch aus, dass eine Spanneinrichtung mit mindestens einem Spannelement vorgesehen ist.

Der Montageplatz bzw. die Spanneinrichtung könnte auch anders gestalteten Bauteilmagazinen zugeordnet werden. Auch für sich gesehen bitet die Spanneinrichtung zusammen mit bestehenden Bauteilmagaziennen die hier beschriebenen Vorteile und kann als separate baugruppe in Form einer nachrüstbaren Einheit zum Einsatz kommen.

Besonders vorteilhaft könnte die Spanneinrichtung zwei gegenüberliegende Spannelemente umfassen, die im Betriebszustand eine Spannkraft auf das erste freie Ende und auf das zweite freie Ende der Tragschiene ausüben. Im Ruhezustand könnten sich die Spannelemente außerhalb des Bereiches der Tragschiene erstrecken. Die beiden Spannelemente könnten zur Erreichung des Betriebszustandes in die freien Enden der Tragschiene eingreifen und die Spannkraft könnte in Richtung der Längsachse der Tragschiene mit gegenläufiger Orientierung, aufeinander zu, wirken. Auf diese Weise erfolgt die positionsgenaue, insbesondere zentrierte, Klemmung bzw. Fixierung der Tragschiene in Richtung der Längsachse. Im Hinblick auf Bauteile, die nicht fix auf einer Tragschiene sitzen, könnte bei entsprechender Ausgestaltung der Spannelemente in vorteilhafter Weise auch die Sicherung der Bauteile in Richtung der Längsachse erreicht werden.

Durch eine vorteilhafte Ausgestaltung der Spannelemente mit einer konischen Formgebung am Eingriffsbereich könnte zusätzlich zur längsaxialen Verklemmung und Positionierung der Tragschiene auch auf die Seitenteile der Tragschiene eingewirkt werden. Dabei könnte die Spannkraft quer zur Längsachse der in einem bevorzugten Ausführungsbeispiel als Hutschiene ausgebildeten Tragschiene auf die Kantenbereiche der Hutschiene einwirken. Die Orientierung der quer zur Längsachse der Hutschiene gerichteten Spannkraft könnte voneinander weg sein, so dass eine Positionierung bzw. Zentrierung der Tragschienenkanten bezogen auf die Längsachse der Tragschiene bewirkt wird. Die genaue Position bzw. Zentrierung der Seitenteile der Tragschiene, insbesondere der Tragschienenkanten, ist besonders bei den bereits erwähnten Hutschienen von großer Wichtigkeit. Der DIN-normierte Schnappfuß der Bauteile wird beim Einschnappen in die ebenfalls DIN-normierte Hutschiene um deren Kante umgekippt, um dann unter der Kante einzuschnappen. Wenn die Seitenteile mit den Tragschienenkanten genau positioniert, zentriert sind, optimiert dies die Montage der Bauteile und vermeidet Verkantungen, Schieflage und dergleichen Qualitätsmängel. Alternativ zu einer Zentrierung im Zusammenhang mit symmetrischen Bauteilen könnten die Spannelemente im Eingriffsbereich auch asymmetrisch gestaltet sein, um eine andere gewünschte Positionierung in Abhängigkeit von der Geometrie anderer Bauteile zu ermöglichen. Weiterführend könnten die Spannelemente zusätzlich oder auch alternativ am Eingriffsbereich auch Ausgestaltungen aufweisen, die eine Ausrichtung der Seitenteile der Tragschiene von außen her beeinflussen. Bei symmetrischen Bauteilen könnte die Spannkraft dann auch quer zur Längsachse, aber nach innen orientiert, wirken. Letztlich ist die Formgebung der Spannelemente im Eingriffsbereich so auf das künftig zu montierende Bauteil abzustimmen, dass die Tragschiene eine für die Montage des Bauteils perfekte Ausrichtung erfährt. Hier könnte auch die Eingriffstiefe der Spannelemente variieren. Zudem besteht die Möglichkeit der Anpassung der Spanneinrichtung auf Montageplätze, die auf anders gestaltete Bauteile abgestimmt sind.

Gemäß einer bevorzugten konstruktiven Umsetzung der Spanneinrichtung der erfindungsgemäßen Anlage könnten die Spannelemente im Ruhezustand unterhalb der Tragschiene angeordnet sein. Auf diese Weise stören sie die Verfahrwege des Werkzeuges oder sonstige bewegliche Bauteile nicht.

Darüber hinaus könnte die Tragschiene nicht nur auf einer Montageplatte befestigt sein, sondern die Montageplatte mit der Tragschiene könnte temporär mit einer bewegbaren Grundplatte verbunden sein. Die Grundplatte könnte Bestanteil eines Trägerblocks sein, welcher die Antriebe für die Grundplatte und die Spannelemente mitumfasst.

Gemäß einem bevorzugten Ausführungsbeispiel könnte die Grundplatte vertikal verfahren werden und in deckungsgleiche Position und in Kontakt zu einer darüber befindlichen Montageplatte mit Tragschiene verbracht werden. Danach könnte die temporäre Verbindung von Grund- und Montageplatte hergestellt werden. Die temporäre Verbindung könnte mechanisch mit Verbindungsmitteln realisiert werden. Danach könnten die Spannelemente in den Betriebszustand überführt werden und die Positionierung - hier Zentrierung - der Tragschiene und ggf. deren Tragschienenkanten vornehmen.

Eine vorteilhafte Verbindungstechnik, die den mechanischen Aufwand und den Zeitaufwand enorm reduziert, könnte durch die Anwendung von Vakuum erreicht werden. Die augenblicklich erreichbare und lösbare Ansaugverbindung ist besonders bevorzugt. Die Grundplatte könnte bspw. eine Nut aufweisen, die der Aufnahme einer Dichtschnur dient. Beim Herstellen des, insbesondere deckungsgleichen, Kontakts zwischen der Grund- und der Montageplatte könnte diese Dichtschnur bereits etwas komprimiert werden. Danach könnte die Positionierung der Tragschiene und/oder auch der Tragschienenkanten über die Spanneinrichtung erfolgen.

Das Vakuum wird vorzugsweise dann eingeschaltet, wenn die Tragschienenpositionierung abgeschlossen ist. Dies wäre dann der Fall, wenn die Positionierung der Tragschiene über die Montageplatte selbst realisiert wird und diese noch bewegbar sein muss. Unabhängig von der Position der Spannelemente nach der Tragschienenpositionierung könnte das Vakuum solange eingeschaltet bleiben, bis die Montageplatte mit den darauf montierten Bauteilen einer nächsten Anwendung oder dem Transport zur nächsten Anwendung zugeführt werden soll. Gerade, wenn der Betriebszustand der Spannelemente beendet wird, nachdem die gewünschten Bauteile auf der Tragschiene aufmontiert sind, ist es von großem Vorteil, dass das Vakuum noch aktiv ist. Hierdurch wird sichergestellt, dass beim Lösen der Spannelemente von der Tragschiene zum Erreichen des Ruhezustandes letztere keinesfalls mitgezogen wird. Sobald die bestückte Montageplatte allein in eine neue Position verbracht werden soll, bspw. auf ein Förderband gelegt werden soll, kann die Lösung der Ansaugverbindung erfolgen.

Es gibt nun verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Ansprüche, andererseits auf die nachfolgende Erläuterung eines Ausführungsbeispiels der Erfindung anhand der Zeichnung zu verweisen. In Verbindung mit der Erläuterung des angeführten Ausführungsbeispiels der Erfindung werden auch im Allgemeinen bevorzugte Ausgestaltungen und Weiterbildungen der Lehre erläutert. In der Zeichnung zeigen
- Fig. 1: in schematischer Darstellung, eine Prinzipskizze zur Erläuterung verschiedener Stellungen einer Aufnahme des erfindungsgemäßen Bauteilmagazins,
- bei a): die Horizontalstellung im Ruhezustand,
- bei b): die Kippstellung,
- bei c): die Horizontalstellung im Betriebszustand,
- Fig. 2: eine Querschnittsdarstellung einer Aufnahme des erfindungsgemäßen Bauteilmagazins mit darin angeordnetem Bauteil,
- Fig. 3: eine Perspektivdarstellung des Entnahmeendes einer Aufnahme des erfindungsgemäßen Bauteilmagazins mit darin angeordneten Bauteilen und mit einem vom Anschlag beabstandeten Führungsdraht,
- Fig. 4: eine Draufsicht auf eine Aufnahme des erfindungsgemäßen Bauteilmagazins mit darin angeordneten Bauteilen und mit einem bleigefüllten Wagen in Kontakt zu dem Bauteil, das dem Beschickungsende am nächsten ist,
- Fig. 5: eine Perspektivdarstellung einer Aufnahme des erfindungsgemäßen Bauteilmagazins mit darin angeordneten Bauteilen und mit Drehlagern auf einer ersten Führungsstange,
- Fig. 6: eine Perspektivdarstellung des Gegenstandes aus Fig. 5, umfassend eine Vertikalstütze des Gestells des erfindungsgemäßen Bauteilmagazins,
- Fig. 7: eine Perspektivdarstellung einer erfindungsgemäßen Anlage, umumfassend das erfindungsgemäße Bauteilmagazin, ein Werkzeug und einen Montageplatz,
- Fig. 8: ein vergrößertes Detail aus Fig. 7 betreffend die Montage des aus dem erfindungsgemäßen Bauteilmagazin entnommenen Bauteils auf der Montageplatte mit zur Verdeutlichung explosionsartig einsehbarer Grundplatte unterhalb der Montageplatte sowie Spannelementen im Ruhezustand,
- Fig. 9: den Gegenstand aus Fig. 8, vergrößert, ohne Werkzeug und daran befindlichem Bauteil, mit zur Verdeutlichung explosionsartig einsehbarer Grundplatte unterhalb der Montageplatte sowie Spannelementen im Ruhezustand,
- Fig. 10: den Gegenstand aus Fig. 9, mit Spannelementen im Betriebszustand und nicht einsehbarer Grundplatte unterhalb der Montageplatte und
- Fig. 11: ein vergrößertes Detail aus Fig. 8, betreffend die vom Werkzeug abgewandte Seite der Montageplatte mit Spannelement im Betriebszustand.

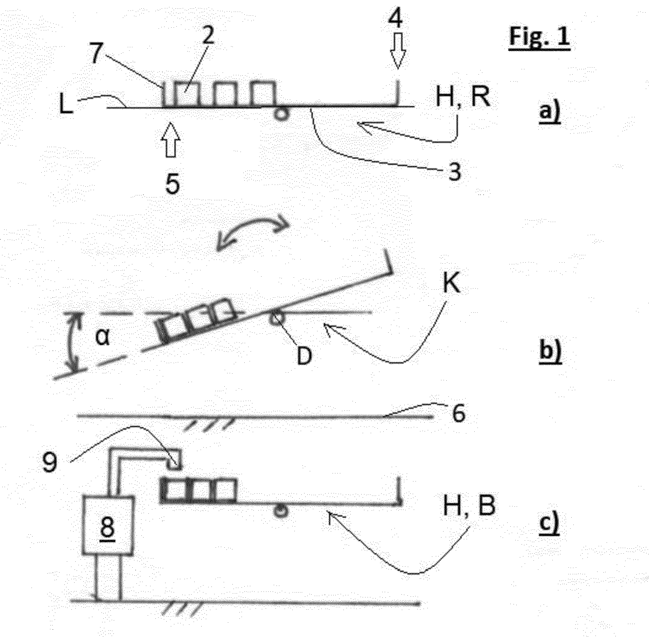

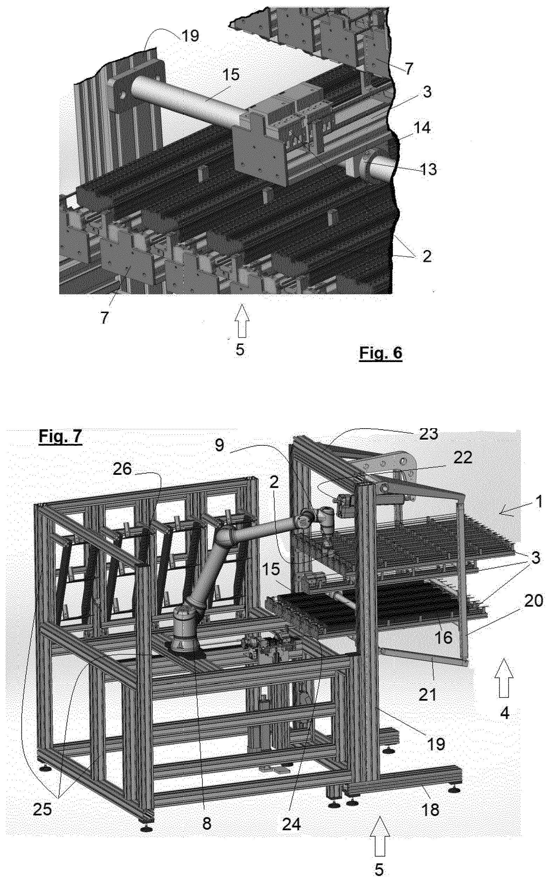

Die Fig. 7 zeigt das erfindungsgemäße Bauteilmagazin 1, welches zur Bereitstellung von Bauteilen 2 dient. Das Bauteilmagazin 1 umfasst gemäß der Prinzipskizze in Fig. 1 eine Aufnahme 3, welche Beschickungsende 4 und ein Entnahmeende 5 aufweist. Am Entnahmeende 5 ist das zu entnehmende Bauteil 2 entnehmbar. Das hier beschriebene Ausführungsbeispiel betrifft ein Bauteilmagazin 1, das nicht nur eine, sondern mehrere über- und nebeneinandergeordnete Aufnahmen 3 aufweist.

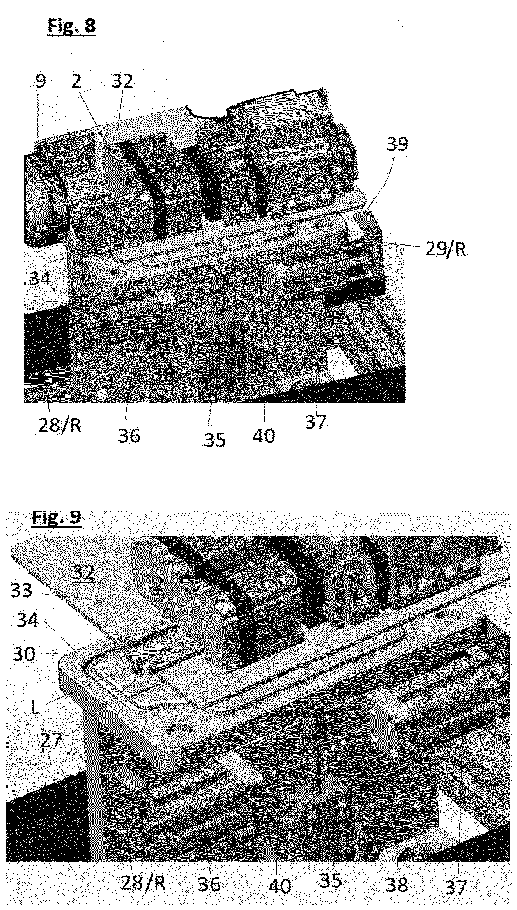

Wie in Fig. 1b) gezeigt, ist die Aufnahme 3 um eine Drehachse D rotierbar und ist zur Vorbereitung der Bauteilentnahme von einer Horizontalstellung H im Ruhezustand R, der in Fig. 1a) gezeigt ist, in eine Kippstellung K verbringbar. In der Kippstellung K weist das Entnahmeende 5 in eine nach unten, zum Boden 6 orientierte Richtung, wobei sich die Bauteile 2 bis zu einem Anschlag 7 am Entnahmeende 5 der Aufnahme 3 bewegen. Zur Entnahme des Bauteils 2 ist die Aufnahme 3 in die Horizontalstellung H, in ihren in Fig. 1c) gezeigten Betriebszustand B, rotierbar. Mit 8 ist ein Werkzeug mit einem Greifarm 9 bezeichnet, der das Bauteil 2, das sich am nächsten zum Anschlag 7 befindet, mittels Greifbacken entnimmt. Die Greifbacken des Greifarms 9 sind besonders deutlich in Fig. 8 erkennbar, sind aber nicht näher bezeichnet. Die in Fig. 1 als Punkt dargestellte und senkrecht in die Blattebene weisende Drehachse D der Aufnahme 3 erstreckt sich quer zur Längsachse L der Aufnahme 3. Zwischen der Ebene der Horizontalstellung H und der Ebene der Kippstellung K der Aufnahme 3 ist ein Drehwinkel α von ca. 30° eingeschlossen.

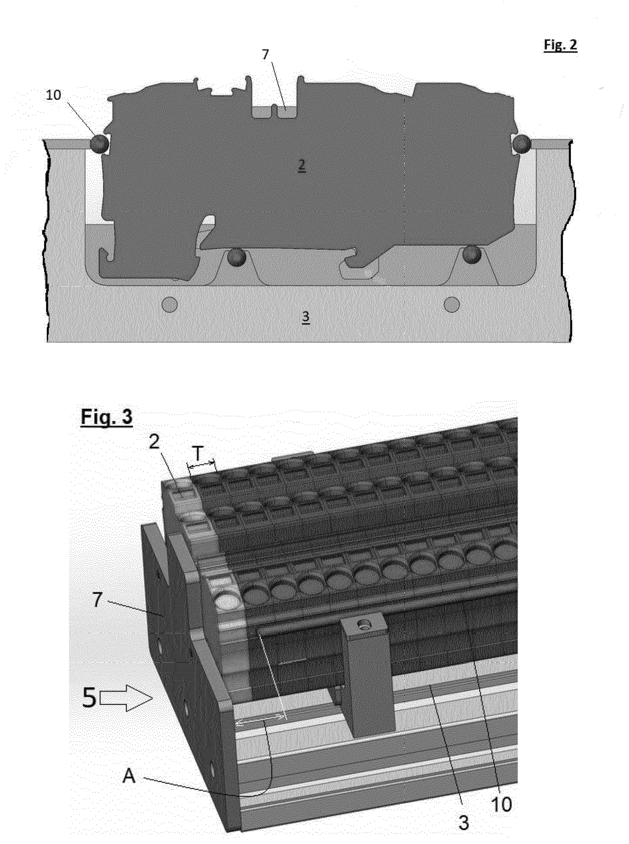

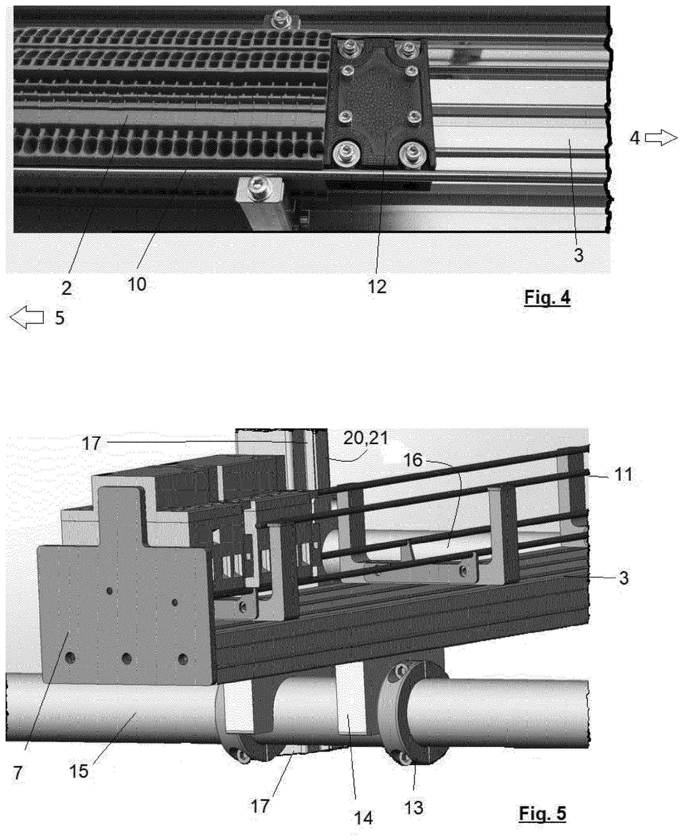

Fig. 2 zeigt, dass die Aufnahme 3 Führungsmittel in Form von Führungsdrähten 10, umfasst, die auf die Formgebung der identisch geformten Bauteile 2 abgestimmt sind. Aus Fig. 3 ergibt sich, dass die Führungsdrähte 10 einen Abstand A zum Anschlag 7 am Entnahmeende 5 aufweisen, dessen Abmessung geringfügig größer ist als die Tiefenabmessung T des zu entnehmenden Bauteils 2. Bei den Bauteilen 2 des hier beschriebenen Ausführungsbeispiels handelt es sich um Bauteile 2 mit besonders geringem Eigengewicht. Zur Sicherstellung der vollständigen Bewegung der in der Aufnahme 3 befindlichen Bauteile 2 während der Kippstellung K bis zum Anschlag 7, ist am Entnahmeende 5 ein mit Blei gefüllter Wagen 12 innerhalb der Aufnahme 3 vorgesehen, der in Fig. 4 dargestellt ist. In der Kippstellung K drückt der Wagen 12 gegen das Bauteil 2, welches dem Beschickungsende 4 am nächsten ist und damit gleichzeitig auch gegen alle Bauteile 2 bis zum Anschlag 7.

Zur Realisierung der Kippstellung K sind der Aufnahme 3 an der Unterseite Drehlager 14 zugeordnet, die im vorliegenden Ausführungsbeispiel auf je einer Führungsstange 15, 16 sitzen. Das Drehlager 14 wird über Feststellringe 13 auf der Führungsstange 15, 16 in Position gehalten und kann auf der Führungsstange 15, 16 drehen. Im vorliegenden Ausführungsbeispiel ist die zum Entnahmeende 5 näher angeordnete Führungsstange 15 fix zwischen zwei Gestellbauteilen des Gestells 18 angeordnet und über ein nicht näher bezeichnetes Lagerbauteil fixiert. Die zum Beschickungsende 4 benachbarte Führungsstange 16 ist gemäß Fig. 5 vertikal beweglich in einer Führung 17 zweier beabstandeter Gestellbauteile des Gestelles 18 gelagert. Das Gestell 18 des erfindungsgemäßen Bauteilmagazins 1 ist in Fig. 7 dargestellt.

Die Fig. 6 und 7 zeigen, dass innerhalb eines Bauteilmagazins 1 mehrere Aufnahmen 3 nebeneinander und übereinander mit verschiedenen Bauteilen 2 angeordnet sind. Weiter ist zu erkennen, dass die zum Entnahmeende 5 benachbarten Führungsstangen 15 in Vertikalstützen 19 des Gestells 18 fixiert ist. Dagegen sind die zum Beschickungsende 4 benachbarten Führungsstangen 16 in Führungen 17 von Vertikalabschnitten 20 von Seitenteilen 21 des Gestells 18 vertikal verschiebbar geführt. Wie in Fig. 1b) gezeigt, bewegt sich das Beschickungsende 4 zum Erreichen der Kippstellung K nach oben und das Entnahmeende 5 nach unten, Richtung Boden 6. Mit 22 ist eine Antriebseinrichtung bezeichnet, die die Auf- und Ab-Bewegung der Führungsstangen 16 in den Vertikalabschnitten 20 bewirkt und am Querträger 23 des Gestells 18 angeordnet ist. Die Vertikalabschnitte 20 der Seitenteile 21 gewähren nur die Bewegung der Führungsstangen 16, benötigen aber keinen eigenen Antrieb. Jede der Aufnahmen 3 kann separat ausgetauscht werden, indem das Drehlager 14 von der Führungsstange 15 durch Anheben außer Kontakt gebracht wird und in Richtung Beschickungsende 4 entfernt wird. Das Einsetzen der Aufnahme 3 erfolgt durch das Aufsetzen des Drehlager 14 auf die Führungsstange 15 und das Positionieren mittels der Feststellringe 13.

Die Fig. 7 zeigt die erfindungsgemäße gesamte Anlage, deren Bestandteil einerseits das erfindungsgemäße Bauteilmagazin 1 ist, andererseits aber auch das Werkzeug 8 und der Montageplatz 24. Das Werkzeug 8 ist im Werkzeuggestell 25 verfahrbar angeordnet. Mit 26 sind Übertragungsmittel von nicht dargestellten Antrieben bezeichnet, die für die Verfahrbarkeit des als Roboter vorliegenden Werkzeuges 8 mit Greifarm 9 sorgen. Der Greifarm 9 hat gerade, ein Bauteil 2 aus der oberen Ebene der Aufnahmen 3 entnommen und schwenkt dieses im nächsten Schritt zum Montageplatz 24, der in den Fig. 8 bis 11 beschrieben ist.

Die Fig. 8 zeigt, dass der Kopf des Greifers 9 ein Bauteil 2 auf eine aus Fig. 9 ersichtliche Trägerschiene 27 aufschiebt, auf der bereits verschiedene Bauteile 2 angeordnet sind. Des Weiteren ist eine im Ruhezustand R befindliche Spanneinrichtung mit gegenüberliegenden Spannelementen 28, 29 dargestellt, wobei sich die Spannelemente 28, 29 unterhalb des Bereiches der Tragschiene 27 erstrecken.

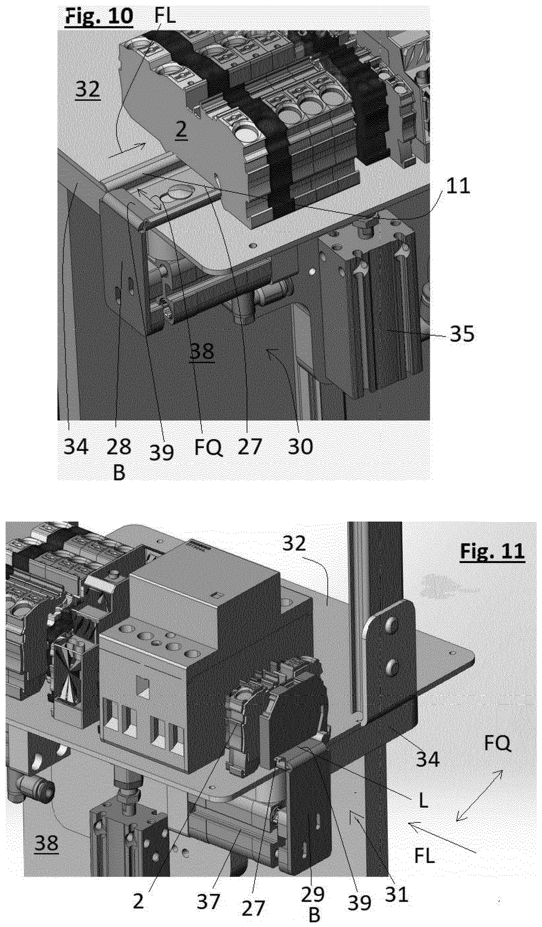

Im Betriebszustand B, der in den Fig. 10 und 11 gezeigt ist, üben das erste Spannelement 28 und das zweite Spannelement 29 jeweils eine Spannkraft FL, FQ auf das erste freie Ende 30 und auf das zweite freie Ende 31 der Tragschiene 27 aus. Dazu greifen die Spannelemente 28, 29 in die freien Enden 30, 31 der Tragschiene 27 ein, wobei die Spannkraft FL in Richtung der in Fig. 9 gezeigten Längsachse L der Tragschiene 27 mit gegenläufiger Orientierung, aufeinander zu, wirkt, wodurch die positionsgenaue Festlegung der Tragschiene 27 erreicht wird.

Die Spannelemente 28, 29 weisen am Eingriffsbereich eine konische Formgebung 39 auf und die Spannkraft FQ wirkt beim fortschreitenden Eingreifen in die freien Enden 30, 31 der Tragschiene 27 in einer Richtung quer zur Längsachse L der Tragschiene 27 mit gegenläufiger Orientierung, voneinander weg. Dabei findet eine exakte Positionierung bzw. Zentrierung der Tragschiene 27 und der Tragschienenkanten 11 dermaßen statt, dass das Bauteil 2, das hier einen nicht weiter beschriebenen DIN-normierten Schnappfuß aufweist, bei der Montage passgenau an der Tragschienenkante 11 aufgesetzt und gekippt werden kann und schließlich unter den Tragschienenkanten 11 einrastet.

Die Tragschiene 27 ist hier als DIN-normierte Hutschiene ausgebildet und ist auf einer Montageplatte 32 mittels Pop-Niete 33 befestigt. Die mit der Tragschiene 27 ausgestattete und ansonsten unbestückte Montageplatte 32 wird mittels Werkzeug 8 von einer hier nicht dargestellten Entnahmestelle oberhalb einer Grundplatte 34 positioniert. Die Grundplatte 34 verfährt mittels Antriebseinrichtung 35 nach oben und kontaktiert die positionierte Montageplatte 2 an deren Unterseite. Wenn der Kontakt hergestellt ist, verfahren zwei weitere Antriebseinrichtungen 36, 37 die Spannelemente 28, 29 aus deren in den Fig. 8 und 9 gezeigten Ruhezustand R in den Betriebszustand B, der in den Figuren 10, 11 gezeigt ist. Im Betriebszustand B der Spannelemente 28, 29 erfolgt die Positionierung bzw. Zentrierung der Tragschiene 27.

Die Grundplatte 34 weist an ihrer Oberseite eine Nut 40 auf, in die eine Dichtschnur einlegbar ist, und ist auf einem Trägerblock 38 angeordnet, über den eine Vakuumbeaufschlagung realisierbar ist. Sobald die Tragschiene 27 positioniert bzw. zentriert ist, wird die Montageplatte 32 über die Grundplatte 34 mit Vakuum beaufschlagt. Danach werden die Bauteile 2 auf der Tragschiene 27 aufgebracht.

Zur Verdeutlichung gewähren die Fig. 8 und 9 durch eine explosionsartige Darstellung den Blick unter die bereits mit Bauteilen 2 bestückte Montageplatte 32 auf die Grundplatte 34.

Das nach der Positionierung der Tragschiene 27 und der Tragschienenkanten 11 eingeschaltete Vakuum bleibt auch eingeschaltet, wenn der Betriebszustand B der Spannelemente 28, 29 beendet wird, das heißt, wenn die Bauteile 2 auf der Tragschiene 27 vollständig aufmontiert sind. Hierdurch wird sichergestellt, dass beim Lösen der Spannelemente 28, 29 zum Erreichen des Ruhezustandes R von der Tragschiene 27 letztere keinesfalls mitgezogen wird.

Wenn die Montageplatte 32 wunschgemäß mit Bauteilen 2 bestückt ist, wird die Grundplatte 34 gemeinsam mit der noch immer mit Vakuum beaufschlagten Montageplatte 32 mittels der Antriebseinrichtung 35 und den gesamten Trägerblock 38 nach unten zu einem nicht dargestellten Fördermittel, bspw. ein Transportband, verfahren. Erst kurz vor der Übergabe der bestückten Montageplatte 32 auf das Transportmittel wird das Vakuum abgeschaltet.

Hinsichtlich weiterer, in den Figuren nicht gezeigter Merkmale wird auf den allgemeinen Teil der Beschreibung verwiesen.

Abschließend sei darauf hingewiesen, dass die erfindungsgemäße Lehre nicht auf das voranstehend erörterte Ausführungsbeispiel eingeschränkt ist. Vielmehr sind die unterschiedlichsten Ausbildungen der Aufnahmen, Kippmechaniken, Bewegungsabläufe und Positionierungstechniken am Montageplatz bezogen auf einen sonstwie gestalteten Träger und/oder bezogen auf eine Montageplatte möglich, solange sie durch die angehängten Ansprüche beschränkt sind.

### Bezugszeichenliste

- 1: Bauteilmagazin
- 2: Bauteil
- 3: Aufnahme
- 4: Beschickungsende
- 5: Entnahmeende
- 6: Boden
- 7: Anschlag
- 8: Werkzeug
- 9: Greifarm
- 10: Führungsdrähte
- 11: Tragschienenkante
- 12: Wagen
- 13: Feststellring
- 14: Drehlager
- 15: Führungsstange
- 16: Führungsstange
- 17: Führung
- 18: Gestell
- 19: Vertikalstützen
- 20: Vertikalabschnitte

- 21: Seitenteile
- 22: Antriebseinrichtung
- 23: Querträger
- 24: Montageplatz
- 25: Werkzeuggestell
- 26: Übertragungsmittel
- 27: Tragschiene
- 28: Erstes Spannelement
- 29: Zweites Spannelement
- 30: Erstes freies Ende
- 31: Zweites freies Ende
- 32: Montageplatte
- 33: Pop-Niete
- 34: Grundplatte
- 35: Antriebseinrichtung
- 36: Antriebseinrichtung
- 37: Antriebseinrichtung
- 38: Trägerblock
- 39: konische Formgebung
- 40: Nut

- D: Drehachse
- H: Horizontalstellung
- K: Kippstellung
- R: Ruhezustand
- B: Betriebszustand
- L: Längsachse
- A: Abstand
- T: Tiefenabmessung
- FL: Spannkraft in Längsrichtung
- FQ: Spannkraft in Querrichtung

## Patentansprüche

1. Bauteilmagazin zur Bereitstellung von Bauteilen (2) mit einer Aufnahme (3), wobei die Aufnahme (3) ein Beschickungsende (4) und ein Entnahmeende (5) aufweist, an dem das zu entnehmende Bauteil (2) entnehmbar ist, wobei die Aufnahme (3) um eine Drehachse (D) rotierbar ist und von einer Horizontalstellung (H) in eine Kippstellung (K) verbringbar ist, wobei in der Kippstellung (K) das Entnahmeende (5) in eine nach unten, zum Boden orientierte Richtung weist und wobei die Aufnahme (3) wieder in die Horizontalstellung (H) rotierbar ist, **dadurch gekennzeichne t**, dass sich die Bauteile (2) zur Vorbereitung der Bauteilentnahme in der Kippstellung (K) bis zu einem Anschlag (7) am Entnahmeende (5) der Aufnahme (3) bewegen und dass zur Entnahme des Bauteils (2) die Aufnahme (3) in die Horizontalstellung (H) rotierbar ist.

2. Bauteilmagazin nach Anspruch 1, **dadurch gekennzeichnet, dass** sich die Drehachse (D) quer zur Längsachse (L) der Aufnahme (3) erstreckt.

3. Bauteilmagazin nach Anspruch 1 oder 2, **dadurch gekennzeichnet, dass** die Aufnahme (3) Führungsmittel, insbesondere in Form von Führungsdrähten (10), umfasst, die auf die Formgebung des Bauteils (2) abgestimmt sind.

4. Bauteilmagazin nach Anspruch 3, **dadurch gekennzeichnet, dass** die Führungsmittel, insbesondere Führungsdrähte (10), einen Abstand (A) zum Anschlag (7) am Entnahmeende (5) aufweisen, dessen Abmessung zumindest geringfügig größer ist als die Tiefenabmessung (T) des zu entnehmenden Bauteils (2).

5. Bauteilmagazin nach einem der Ansprüche 1 bis 4, **dadurch gekennzeichnet, dass** zur Sicherstellung der vollständigen Bewegung der in der Aufnahme (3) befindlichen Bauteile (2) während der Kippstellung (K) bis zum Anschlag (7) am Entnahmeende (5) ein Gewicht, insbesondere ein mit Blei gefüllter Wagen (12), innerhalb der Aufnahme (3) vorgesehen ist, welches insbesondere auf das Bauteil (2) einwirkt, das dem Beschickungsende (4) am nächsten ist.

6. Bauteilmagazin nach einem der Ansprüche 1 bis 5, **dadurch gekennzeichnet, dass** zur Realisierung der Kippstellung (K) der Aufnahme (3) an der Unterseite mindestens ein Drehlager (14) zugeordnet ist, das auf mindestens einer Führungsstange (15, 16) sitzt, wobei zumindest eine Führungsstange (15, 16) vertikal beweglich in Führungen (17) beabstandeter Gestellbauteile eines Gestelles (18) gelagert ist.

7. Bauteilmagazin nach einem der Ansprüche 1 bis 6, **dadurch gekennzeichnet, dass** innerhalb eines Bauteilmagazins (1) mehrere Aufnahmen (3) angeordnet sind.

8. Anlage zur Montage von Bauteilen auf einer Tragschiene (27), umfassend ein Bauteilmagazin (1) nach einem der Ansprüche 1 bis 7, ein Werkzeug (9) zur Entnahme des Bauteils (2) aus dem Bauteilmagazin (1) und zur Montage des Bauteils (2) auf der Tragschiene (27),
**dadurch gekennzeichnet,**
**dass** eine Spanneinrichtung mit mindestens einem Spannelement (28, 29) vorgesehen ist, die im Betriebszustand (B) eine Spannkraft (FL, FQ) auf die Tragschiene (27) ausübt.

9. Anlage nach Anspruch 8, **dadurch gekennzeichnet, dass** zwei gegenüberliegende Spannelemente (28, 29) vorgesehen sind, dass das erste Spannelement (28) in das erste freie Ende (30) eingreift, dass das zweite Spannelement (29) in das zweite freie Ende (31) der Tragschiene (27) eingreift, wobei die Spannkraft in Richtung der Längsachse (L) der Tragschiene (27) mit gegenläufiger Orientierung, aufeinander zu, wirkt und die Tragschiene (27) positioniert und eingeklemmt ist.

10. Anlage nach Anspruch 8 oder 9, **dadurch gekennzeichnet, dass** das Spannelement (28, 29) eine konische Formgebung (39), aufweist und die Spannkraft (FQ) beim fortschreitenden Eingreifen in die freien Enden (30, 31) der Tragschiene (27) in einer Richtung quer zur Längsachse (L) der Tragschiene (27) mit gegenläufiger Orientierung, voneinander weg, wirkt und so die Tragschiene (27), insbesondere deren Tragschienenkanten (11), positioniert sind.

11. Anlage nach einem der Ansprüche 8 bis 10, **dadurch gekennzeichnet, dass** sich die Spannelemente (28, 29) im Ruhezustand (R), insbesondere nach dem Aufbringen der Bauelemente (2) auf die Tragschiene (27), unterhalb der Tragschiene (27) erstrecken.

12. Anlage nach einem der Ansprüche 8 bis 11, **dadurch gekennzeichnet, dass** die Tragschiene (27) auf einer Montageplatte (32) befestigt ist und dass die Montageplatte (32) mit einer bewegbaren Grundplatte (34) zusammenwirkt.

13. Anlage nach Anspruch 12, **dadurch gekennzeichnet, dass** die Grundplatte (34) und die Montageplatte (32) temporär, lösbar miteinander verbindbar sind.

14. Anlage nach Anspruch 13, **dadurch gekennzeichnet, dass** die temporäre Verbindung zwischen der Grundplatte (34) und der Montageplatte (32) durch das Anlegen eines Vakuums hergestellt ist und dass die Vakuumbeaufschlagung vorzugsweise dann stattfindet, wenn die Positionierung der Tragschiene (27) abgeschlossen ist.

15. Anlage nach Anspruch 13 oder 14, **dadurch gekennzeichnet, dass** temporäre Verbindung der Grundplatte (34) und der Montageplatte (32) dann gelöst ist, wenn die wunschgemäß mit Bauteilen (2) bestückte Montageplatte (32) anderweitig einsetzbar ist.

## Claims

1. A component magazine for providing components (2) with a receptacle (3), wherein the receptacle (3) has a feed end (4) and a removal end (5) at which the component (2) to be removed can be removed, wherein the receptacle (3) can be rotated about an axis of rotation (D) and can be brought from a horizontal position (H) into a tilt position (K), wherein in the tilt position (K), the removal end (5) points in a downward direction oriented towards the floor, and wherein the receptacle (3) can be rotated back into the horizontal position (H), **characterized in that** in preparation for component removal in the tilt position (K), the components (2) move up to a stop (7) at the removal end (5) of the receptacle (3) and **in that** the receptacle (3) can be rotated into the horizontal position (H) in order to remove the component (2).

2. The component magazine according to claim 1, **characterized in that** the axis of rotation (D) extends transverse to the longitudinal axis (L) of the receptacle (3).

3. The component magazine according to claim 1 or 2, **characterized in that** the receptacle (3) comprises guide means, in particular in the form of guide wires (10), which are adapted to the shape of the component (2).

4. The component magazine according to claim 3, **characterized in that** the guide means, in particular guide wires (10), have a distance (A) from the stop (7) at the removal end (5), the dimension of which is at least slightly greater than the depth dimension (T) of the component (2) to be removed.

5. The component magazine according to any one of claims 1 to 4, **characterized in that** in order to ensure the complete movement of the components (2) located in the receptacle (3) during the tilt position (K) up to the stop (7) at the removal end (5), a weight, in particular a carriage (12) filled with lead, is provided within the receptacle (3), which weight acts in particular on the component (2) which is closest to the feed end (4).

6. The component magazine according to any one of claims 1 to 5, **characterized in that** for implementing the tilt position (K), at least one pivot bearing (14), which is seated on at least one guide rod (15, 16), is assigned to the receptacle (3) on the underside, wherein at least one guide rod (15, 16) is mounted so as to be vertically movable in guides (17) of spaced-apart frame components of a frame (18).

7. The component magazine according to any one of claims 1 to 6, **characterized in that** a plurality of receptacles (3) are arranged within a component magazine (1).

8. An installation for mounting components on a support rail (27), comprising a component magazine (1) according to any one of claims 1 to 7, a tool (9) for removing the component (2) from the component magazine (1) and for mounting the component (2) on the support rail (27),
**characterized in**
**that** a clamping device with at least one clamping element (28, 29) is provided, which, in the operating state (B), exerts a clamping force (FL, FQ) on the support rail (27).

9. The installation according to claim 8, **characterized in that** two opposing clamping elements (28, 29) are provided, **in that** the first clamping element (28) engages in the first free end (30), **in that** the second clamping element (29) engages in the second free end (31) of the support rail (27), wherein the clamping force acts in the direction of the longitudinal axis (L) of the support rail (27) with opposite orientation, towards one another, and the support rail (27) is positioned and clamped.

10. The installation according to claim 8 or 9, **characterized in that** the clamping element (28, 29) has a conical shape (39), and the clamping force (FQ), while progressively engaging in the free ends (30, 31) of the support rail (27), acts in a direction transverse to the longitudinal axis (L) of the support rail (27) with opposite orientation, away from one another other, and thus the support rail (27), in particular the support rail edges (11) thereof, are positioned.

11. The installation according to any one of claims 8 to 10, **characterized in that** the clamping elements (28, 29) extend below the support rail (27) in the resting state (R), in particular after placing the components (2) on the support rail (27).

12. The installation according to any one of claims 8 to 11, **characterized in that** the support rail (27) is fixed on a mounting plate (32) and **in that** the mounting plate (32) cooperates with a movable base plate (34).

13. The installation according to claim 12, **characterized in that** the base plate (34) and the mounting plate (32) can be temporarily and releasably connected to one another.

14. The installation according to claim 13, **characterized in that** the temporary connection between the base plate (34) and the mounting plate (32) is established by the application of a vacuum and **in that** the action of the vacuum preferably takes place when the positioning of the support rail (27) is completed.

15. The installation according to claim 13 or 14, **characterized in that** the temporary connection between the base plate (34) and the mounting plate (32) is released when the mounting plate (32), which is fitted with components (2) as desired, can be used elsewhere.

## Revendications

1. Magasin de composants pour la fourniture de composants (2) avec un logement (3), sachant que le logement (3) comporte une extrémité de chargement (4) et une extrémité de prélèvement (5) sur laquelle le composant à prélever (2) peut être prélevé, sachant que le logement (3) peut tourner autour d'un axe de rotation (D) et peut être placé d'une position horizontale (H) dans une position de basculement (K), sachant que dans la position de basculement (K), l'extrémité de prélèvement (5) est dirigée vers le fond dans une direction orientée vers le bas et sachant que le logement (3) peut être à nouveau tourné dans la position horizontale (H), **caractérisé en ce que** les composants (2) pour la préparation du prélèvement de composants se déplacent dans la position de basculement (K) jusqu'à une butée (7) à l'extrémité de prélèvement (5) du logement (3) et **en ce que** le logement (3) peut être tourné dans la position horizontale (H) pour le prélèvement du composant (2).

2. Magasin de composants selon la revendication 1, **caractérisé en ce que** l'axe de rotation (D) s'étend transversalement à l'axe longitudinal (L) du logement (3).

3. Magasin de composants selon la revendication 1 ou 2, **caractérisé en ce que** le logement (3) comprend des moyens de guidage, en particulier sous la forme de fils de guidage (10), qui sont adaptés à la conformation du composant (2).

4. Magasin de composants selon la revendication 3, **caractérisé en ce que** les moyens de guidage, en particulier les fils de guidage (10), comportent une distance (A) par rapport à la butée (7) à l'extrémité de prélèvement (5) dont la dimension est au moins faiblement supérieure à la dimension de profondeur (T) du composant à prélever (2).

5. Magasin de composants selon l'une quelconque des revendications 1 à 4, **caractérisé en ce que** pour assurer le mouvement complet des éléments (2) se trouvant dans le logement (3) pendant la position de basculement (K) jusqu'à la butée (7) à l'extrémité de prélèvement (5), un poids, en particulier un chariot (12) rempli de plomb, est prévu à l'intérieur du logement (3), lequel agit en particulier sur le composant (2) qui est le plus proche de l'extrémité d'alimentation (4).

6. Magasin de composants selon l'une quelconque des revendications 1 à 5, **caractérisé en ce que** pour réaliser la position de basculement (K) du logement (3), au moins un coussinet de pivotement (14) est attribué à la face inférieure, qui porte sur au moins une barre de guidage (15, 16), sachant qu'au moins une barre de guidage (15, 16) est logée verticalement mobile dans les guidages (17) des composants de châssis espacés d'un châssis (18).

7. Magasin de composants selon l'une quelconque des revendications 1 à 6, **caractérisé en ce que** à l'intérieur d'un magasin de composants (1) sont disposés plusieurs logements (3).

8. Installation de montage de composants sur un profilé de support (27), comprenant un magasin de composants (1) selon l'une quelconque des revendications 1 à 7, un outil (9) pour l'enlèvement du composant (2) du magasin de composants (1) et pour le montage du composant (2) sur le profilé de support (27),
**caractérisé en ce qu'**
un système de serrage avec au moins un élément de serrage (28, 29) est prévu, qui exerce à l'état de fonctionnement (B) une force de serrage (FL, FQ) sur le profilé de support (27).

9. Installation selon la revendication 8, **caractérisée en ce que** deux élément de serrage (28, 29) opposés sont prévus, **en ce que** le premier élément de serrage (28) vient en prise dans la première extrémité libre (30), **en ce que** le deuxième élément de serrage (29) vient en prise dans la deuxième extrémité libre (31) du profilé de support (27), sachant que la force de serrage agit en direction de l'axe longitudinal (L) du profilé de support (27) avec une orientation contraire l'un par rapport à l'autre et positionne et serre le profilé de support (27).

10. Installation selon la revendication 8 ou 9, **caractérisée en ce que** deux éléments de serrage l' élément de serrage (28, 29) comporte une conformation conique (39) et la force de serrage (FQ) agit lors de la prise progressive dans les extrémités libres (30, 31) du profilé de support (27) s'écartant l'une de l'autre dans une direction transversalement à l'axe longitudinal (L) du profilé de support (27) avec une orientation contraire et le profilé de support (27), en particulier les bords de profilé de support de celui-ci (11), sont ainsi positionnés.

11. Installation selon l'une quelconque des revendications 8 à 10, **caractérisée en ce que** les éléments de serrage (28, 29) s'étendent à l'état de repos (R), sous le profilé de support (27), en particulier après la mise en place des composants (2) sur le profilé de support (27).

12. Installation selon l'une quelconque des revendications 8 à 11, **caractérisée en ce que** le profilé de support (27) est fixé sur une plaque de montage (32) et **en ce que** la plaque de montage (32) coopère avec une plaque de base mobile (34).

13. Installation selon la revendication 12, **caractérisée en ce que** la plaque de base (34) et la plaque de montage (32) peuvent être reliées temporairement l'une à l'autre de façon amovible.

14. Installation selon la revendication 13, **caractérisée en ce que** la liaison temporaire entre la plaque de base (34) et la plaque de montage (32) est réalisée par l'application d'un vide et **en ce que** l'application de vide a lieu ensuite de préférence lorsque le positionnement du profilé de support (27) est terminé.

15. Installation selon la revendication 13 ou 14, **caractérisée en ce que** la liaison temporaire de la plaque de base (34) et de la plaque de montage (32) est ensuite défaite, lorsque la plaque de montage (32) équipée conformément de composants (2) peut être insérée autrement.
